Europäisches Patentamt

European Patent Office

Office européen des brevets

(11) Publication number: **0 284 867**
**A2**

## (12) EUROPEAN PATENT APPLICATION

(21) Application number: **88104018.2**

(22) Date of filing: **14.03.88**

(51) Int. Cl.⁴ **H01J 37/32 , C23F 4/00**

(30) Priority: **03.04.87 US 33960**

(43) Date of publication of application:
**05.10.88 Bulletin 88/40**

(84) Designated Contracting States:
**DE FR GB**

(71) Applicant: **TEGAL CORPORATION**
**11 Digital Drive**
**Novato California 94947(US)**

(72) Inventor: **Wicker, Thomas E.**
**1414 Louisianna Street**
**Vallejo California 94590(US)**

(74) Representative: **Ibbotson, Harold et al**
**Motorola Ltd Patent and Licensing**
**Operations - Europe Jays Close Viables**
**Industrial Estate**
**Basingstoke Hampshire RG22 4PD(GB)**

(54) **Dry etching apparatus using surface magnetic field confinement of plasma.**

(57) An improved plasma reactor apparatus and method are disclosed. Improved uniformity of etching and an increased etch rate are achieved in a triode reactor through the use of a plasma confining multi-polar magnetic field which contains the plasma and which is generated by a plurality of bar magnets located on the sides and top of the reactor.

*FIG. 1*

# DRY ETCHING APPARATUS USING SURFACE MAGNETIC FIELD CONFINEMENT OF PLASMA

## Background of the Invention

This invention pertains to an improved plasma reactor utilizing magnetically confined plasma.

Plasma etching is a well known dry etching technique which physically and chemically etches a workpiece.

The basic plasma reactor consists of an evacuated chamber with three electrodes. An etching gas, such as $CF_4$, is introduced into the chamber and is disassociated by the flow of energy between electrodes, to form a plasma. One of the electrodes acts as a stage for the workpiece. The workpiece is then physically and chemically etched by the plasma. The disassociation of the etching gas produces ions with high kinetic energy which bombard the workpiece thereby physically etching it. The disassociation of the etching gas also produces reactive neutrals which react with the workpiece thus chemically etching it.

A problem with this technique is that the ionization rate is low so that the ion to neutral flux ratio to the workpiece is too small in many cases to give an etch with the desired characteristics. A low ion to neutral flux ratio many times results in undercutting of the etch mask with poor control of critical dimensions and post etch residues.

In prior art, attempts have been made to circumvent these problems by creating magnetic fields, and passing these magnetic fields over and through the workpiece in order to form a quick and uniform etch, as in U.S. Patent 4,526,643 entitled "Dry Etching Apparatus Using Reactive Ions". The use of magnet field which pass through the workpiece results in an etch with unacceptable levels of non-uniformity.

In U.S. Patent 4,572,759, entitled "Triode Plasma Reactor With Magnetic Enhancement", issued February 25, 1986, magnets are used with a triode reactor in a "magnetron" type device for the enhancement of the etch. It uses permanent magnets to establish a magnetic field parallel to the surface of the wafer and perpendicular to the plasma sheath electric field (the term magnetron refers to this general technique of manipulating plasma current-voltage characteristics by application of crossed electric and magnetic fields). Charged species precess about the magnetic field lines due to the Lorentz force. The ions follow the electric field lines unperturbed, to provide energetic bombardment of the surface. The electrons sweep out a larger volume, and have an increased residence time in the plasma due to the magnetic field, resulting in larger ionization and dissociation rates of the neutral gas in the volume above the wafer. The problem with this technique is that it is difficult to produce uniform magnetic fields over a large area. The magnetic field is not uniform over the entire wafer and results in non-uniform etching. A good approximation to a uniform field can be made for small wafers, but it is not feasible to scale up this technique to the large wafer sizes of the future.

## Summary of the Invention

The present invention pertains to a RF powered plasma reactor which utilizes magnets to contain the plasma in a triode reactor. These magnets are located around the periphery of the reactive volume of a plasma reactor and contain the plasma by forming a multi-polar magnetic field, the magnetic lines of which do not pass near the workpiece. The plasma reactor includes a system for the input of an etching gas and the removal of the reaction products.

It is an object of the present invention to provide a new and improved plasma etch reactor with magnetically contained plasma.

It is a further object of the present invention to provide a plasma reactor which will uniformly etch a substrate.

It is a further object of the present invention to provide a plasma reactor with an increased rate of etch.

A further object of the present invention is to decrease the damage to substrates and to increase the utilization of the feed gas.

A further object of the present invention is to produce a cleaner and more anisotropic etch.

These and other objects of this invention will become apparent to those skilled in the art upon consideration of the accompanying specification, claims and drawings.

## Brief Description of the Drawings

Referring to the drawings, wherein like characters indicate like parts throughout the figures:

FIG. 1 is a cross-sectional view of a plasma reactor with magnetically contained reactive ions embodying the present invention; and

FIG. 2 is a top view of a plasma reactor with magnetically contained reactive ions embodying the present invention.

## Description of the Preferred Embodiments

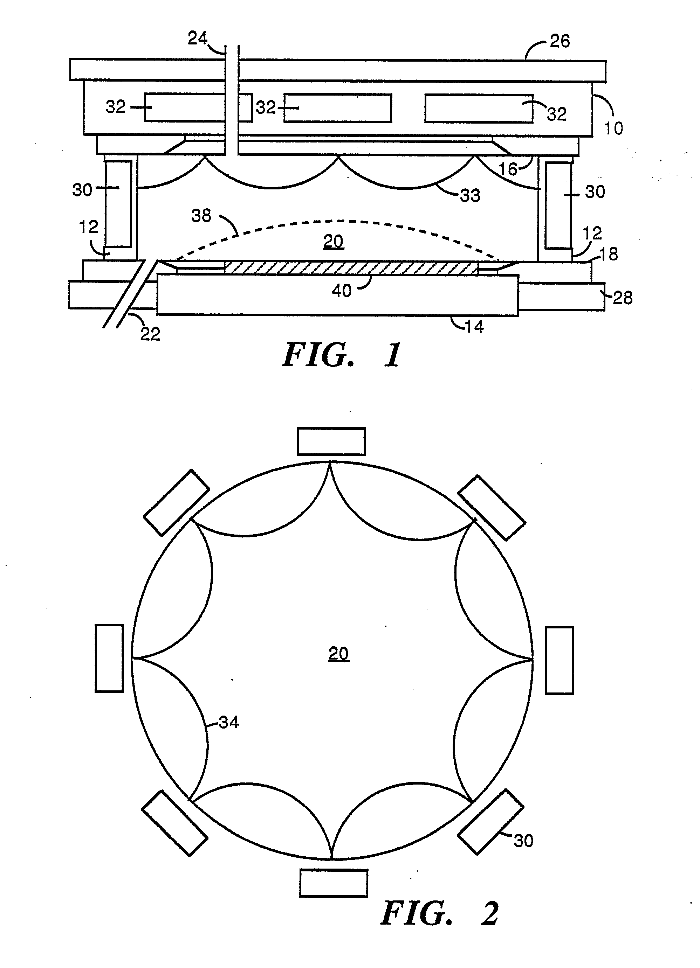

A preferred embodiment of the apparatus in accordance with the invention is illustrated in cross-section in FIG. 1. The apparatus includes a first electrode 10, a second electrode 12, and a third electrode 14. The first and third electrodes are generally circular and the second electrode is ring shaped. Ring shaped ceramic insulators 16 and 18 provide electrical insulation between the first and second and the second and third electrodes, respectively. Together the three electrodes and two ceramic rings bound a generally cylindrical reaction volume 20. Although not shown, the electrodes can be provided with temperature control means such as water cooling.

A gas inlet 22 provides for the ingress of etching gas to the reaction volume 20. A gas outlet 24 provides for egress of reaction products from the reaction volume under the influence of a vacuum pump (not shown). It will be understood by those skilled in the art that inlet 22 and egress 24 are simplified representations included to illustrate a complete structure simply for purposes of this description. A top plate 26 and a clamp ring 28 mechanically hold the plasma reactor components together. For more detailed description of a triode reactor, its circuitry and operation refer to U.S. Patent No. 4,464,223, entitled "Plasma Reactor Apparatus and Method", issued August 7, 1984.

To the basic RF powered triode reactor mentioned, a plurality of bar magnets are added. Magnets 30 are fixedly embedded around the circumference of electrode 12 leaving a given thickness of electrode 12 separating magnets 30 from reactive volume 20. Magnets 30 are in parallel relation to each other, and extend from approximately the bottom to the top of electrode 12 in an alternating pattern of polarity. Additional bar magnets 32 are embedded in the top electrode 10 leaving a given thickness of electrode 10 separating magnets 32 from reactive volume 20. Magnets 32 are in parallel relation to each other generally extending across a cordal length of electrode 10 and generally between the ends of magnets 30.

Bar magnets 30 and 32 form magnetic cusps 33 and 34 as shown in FIG. 1 and FIG. 2, respectively. In the preferred embodiment, a line-cusp configuration is used, but other configurations such as checkerboard could be used. The magnetic cusps provide a surface magnetic field which penetrates approximately 10 centimeters in from the walls, leaving a central field-free region in the reactor. The wafer is located in this field-free region, unlike the magnetron designs. Because of this, the reactor is easily scalable to large sizes which will be needed for the increased wafer sizes of the future. The line cusp magnetic field 33, 34 confines ionizing electrons, preventing them from recombining on the walls of the reactor, and thus increasing their concentration in the plasma thereby providing a greater density of the reactive species for etching. These cusp magnetic fields interact to define a substantially dome shaped ion confining multipole magnetic field 38. The higher energy electrons are reflected from the magnetic dome 38 and plasma ions and electrons are confined by both the magnetic field and the self-consistent electric fields present. The confinement of higher energy electrons is due to the adiabatic invariance of the magnetic moment of the electrons. The magnetic field acts to keep electrons in a confined area, where they repeatedly collide with the etching gas to produce a high density of reactant. Loss of ions is minimized due to self-consistent electric fields in the plasma boundary.

Magnetic cusps 33 and 34, which define dome 38, do not contact workpiece 40 so there are substantially no magnetic lines passing through workpiece 40. This increases uniformity of etch, because it has been found that the reactive species are formed in greater concentration at the magnetic lines. If the lines pass through workpiece 40 there will be areas of greater plasma concentration and areas of less plasma concentration, resulting in a non-uniform etch.

The following are non-limiting examples which serve to further illustrate practice of the invention and to disclose preferred embodiments contemplated by the inventor.

Example 1: a plurality of silicon wafers were thermally oxidized to grow a silicon dioxide layer. This layer was then etched in a magnetically enhanced reactor as shown in FIG. 1. Etch rates of greater than 3500 Angstroms per minute were achieved using the etch gas $C_2F_6$ at a total flow of 5 SCCM and an internal pressure of one millitorr. The triode had a frequency of 13.56 mhz applied to the side electrode and 100 khz applied to the wafer electrode. The 13.56 mhz electrode was supplied with 600 watts of power and the 100 khz electrode was supplied with 50 watts of power.

Example 2: A plurality of silicon wafers were thermally oxidized to grow a layer of silicon dioxide. A layer of aluminum-silicon-copper film (97%-1%-2%) was applied over the silicon dioxide. The etching gas used was a mixture of 60% $SiCL_4$ and 40% $Cl_2$. At an internal pressure of 10 millitorr and with a total flow of etching gas at 80 SCCM, etch rates of greater than 6000 Angstroms per minute for the film were achieved. The triode was set with 600 watts of power at a frequency of 13.56 mhz applied to the side electrode and 50 watts of power at a frequency of 100 khz applied to the wafer electrode. The etches were always anisotropic with no undercut. Non-uniformity was typically 10%.

There is thus provided for the present invention a substantially improved plasma reactor with magnetically contained plasma. The magnetic field confines the higher energy electrons, which increases the ionization rate in the plasma volume. The self-consistent electric fields resulting from the condition, wherein the positive ion density equals the sum of the electron density and the negative ion density in the bulk plasma, serve to confine the ions. The electron density is higher due to magnetic confinement so the ion density is increased due to the afore said conditions and the higher creation rate. Thus, the utilization of the etching gas, from which the ions are derived, is increased. It is apparent that there has been provided, in accordance with the invention, an improved plasma reactor apparatus and method which fully meet the objects set forth above.

While I have shown and described specific embodiments of this invention, further modifications and improvements will occur to those skilled in the art. For example, while the preferred embodiment of the plasma reactor is for etching, other uses, such as deposition and sputtering are possible. I desire it to be understood, therefore, that this invention is not limited to the particular form shown and I intend in the appended claims to cover all modifications which do not depart from the spirit and scope of this invention.

## Claims

1. In a dry etching apparatus having a chamber for containing a plasma glow discharge and a workpiece, the improvement comprising a plasma confining, multi-polar magnetic field (33,34) having a substantially field-free region (38) containing said workpiece so that the magnetic field does not pass through said workpiece.

2. The dry etching apparatus as set forth in claim 1 wherein said apparatus comprises a plurality of bar magnets (30) arranged in anti-parallel configuration about said chamber.

3. The dry etching apparatus as claimed in claim 2 wherein said chamber comprises a cylindrical sidewall having a central axis, a top plate, and a bottom plate, and wherein each of the plurality of magnets are elongated and are generally regularly spaced around said cylindrical sidewall, each extending substantially parallel to and equally spaced from said axis, and further comprising additional elongated permanent magnets (32) located within said top plate in anti-parallel relation.

FIG. 1

FIG. 2